(19) Europäisches Patentamt
European Patent Office
Office européen des brevets

(11) **EP 2 245 473 B1**

(12) **EUROPÄISCHE PATENTSCHRIFT**

(45) Veröffentlichungstag und Bekanntmachung des Hinweises auf die Patenterteilung:
**29.08.2012   Patentblatt 2012/35**

(21) Anmeldenummer: **09712988.6**

(22) Anmeldetag: **23.02.2009**

(51) Int Cl.:
*G01R 31/26* (2006.01)   *H01L 21/66* (2006.01)

(86) Internationale Anmeldenummer:
**PCT/EP2009/001277**

(87) Internationale Veröffentlichungsnummer:
**WO 2009/103566 (27.08.2009 Gazette 2009/35)**

(54) **MESSVERFAHREN UND VORRICHTUNG ZUR CHARAKTERISIERUNG EINES HALBLEITERBAUELEMENTS**

MEASURING METHOD AND DEVICE FOR CHARACTERIZING A SEMICONDUCTOR COMPONENT

PROCÉDÉ DE MESURE ET DISPOSITIF POUR CARACTÉRISER UN COMPOSANT À SEMI-CONDUCTEURS

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **22.02.2008   DE 102008010672**

(43) Veröffentlichungstag der Anmeldung:
**03.11.2010   Patentblatt 2010/44**

(73) Patentinhaber:
• **Fraunhofer-Gesellschaft zur Förderung der angewandten Forschung e.V.**
  **80686 München (DE)**
• **Christian-Albrechts-Universität zu Kiel**
  **24118 Kiel (DE)**
• **Albert-Ludwigs-Universität Freiburg**
  **79085 Freiburg (DE)**

(72) Erfinder:
• **CARSTENSEN, Jürgen**
  **24146 Kiel (DE)**
• **SCHÜTT, Andreas**
  **24116 Kiel (DE)**
• **FÖLL, Helmut**
  **24248 Mönkeberg (DE)**
• **WARTA, Wilhelm**
  **70110 Freiburg (DE)**
• **KASEMANN, Martin**
  **79211 Denzlingen (DE)**

(74) Vertreter: **Dicker, Jochen et al**
**Lemcke, Brommer & Partner**
**Patentanwälte**
**Bismarckstraße 16**
**76133 Karlsruhe (DE)**

(56) Entgegenhaltungen:
**EP-A- 0 887 652      EP-A- 1 758 178**
**WO-A-2007/041758   WO-A-2007/128060**
**WO-A-2008/014537**

**Beschreibung**

Die Erfindung betrifft ein Messverfahren zur Charakterisierung eines Halbleiterbauelementes gemäß Oberbegriff des Anspruchs 1 sowie eine Messvorrichtung für ein Halbleiterbauelement gemäß Oberbegriff des Anspruchs 15.

Zur Bestimmung physikalischer Parameter und insbesondere Verlustmechanismen in Halbleiterbauelementen sind ortsauflösende Messverfahren vorteilhaft, da hierdurch bestimmten örtlichen Teilbereichen des Halbleiterbauelementes bestimmte physikalische Parameter oder Verlustmechanismen zugeordnet werden können und somit beispielsweise örtliche Inhomogenitäten im Herstellungsprozess des Halbleiterbauelementes in einfacher Weise erkannt und analysiert werden können.

Diese Verfahren finden insbesondere Anwendung bei der Charakterisierung von Halbleiterbauelementen in Form von Halbleiter-Solarzellen oder von Vorstufen einer solchen Solarzelle im Entwicklungsprozess, d.h. einem Halbleiterelement, welches zumindest einen pn-Übergang aufweist. Im Folgenden wird der Begriff "Solarzelle" sowohl zur Bezeichnung der fertiggestellten Solarzelle, als auch für deren Vorstufen im Herstellungsprozess verwendet, sofern diese Vorstufe bereits einen pn-Übergang aufweist.

Zur ortsaufgelösten Vermessung einer Solarzelle sind Messvorrichtungen bekannt, welche eine Beleuchtungsvorrichtung, eine Messelektronik und ein Kamerasystem oder eine sonstige ortsauflösende Detektionseinheit umfassen. Mittels der Beleuchtungsvorrichtung wird die Solarzelle typischerweise ganzflächig von der Vorder- und/oder Rückseite beleuchtet. Die dadurch generierten freien Ladungsträgerpaare werden am pn-Übergang der Solarzelle getrennt.

Die Messelektronik ist typischerweise mit den elektrischen Kontakten der Solarzelle verbunden, so dass mittels der Messelektronik der Arbeitspunkt der Solarzelle, d. h. die Strom- oder Spannungswerte an den elektrischen Kontakten vorgebbar sind.

WO 2007/041758 A1 offenbart ein Verfahren und eine Vorrichtung zum Prüfen einer Halbleiterstruktur basierend auf einem indirekten Halbleiter. Hierbei wird die Halbleiterstruktur mit Anregungsstrahlung beaufschlagt und die von der Halbleiterstruktur ausgehende Strahlung ortsaufgelöst gemessen.

EP 1 758 178 A2 offenbart ein Verfahren und eine Vorrichtung zur Ermittlung von Produktionsfehlern in einem Halbleiterbauelement. Hierbei wird das Halbleiterbauelement zur Lumineszenz angeregt und deren ortsaufgelöste Intensitätsverteilung wird zur Ermittlung der ortsaufgelösten Verteilung des elektrischen Potentials in dem Halbleiterbauelement bestimmt.

EP 08 887 652 A2 offenbart eine Vorrichtung und ein Verfahren zur Charakterisierung einer Solarzelle. Hierzu wird ein vorgegebener Teilbereich einer lichtempfindlichen Oberfläche der Solarzelle beleuchtet und die Strom-Spannungskennlinie der Solarzelle wird gemessen.

Zur quantitativen und qualitativen Analyse werden Messungen an verschiedenen Arbeitspunkten entlang der Strom/Spannungskennlinie der Solarzelle durchgeführt, insbesondere um verschiedene ortsabhängige Parameter der Solarzelle voneinander trennen zu können.

Typische Arbeitspunkte sind hierbei Kurzschlussbedingungen (kein Spannungsabfall zwischen den elektrischen Kontakten der Solarzelle), Leerlaufspannung (kein Stromfluss zwischen den elektrischen Kontakten der Solarzelle) und der optimale Arbeitspunkt, bei dem das Produkt aus entnommenem Strom und anliegender Spannung maximal ist.

Der für eine Messung gewählte Arbeitspunkt auf der Strom/Spannungskennlinie der Solarzelle bestimmt maßgeblich, welche lokalen Eigenschaften messbar sind. So ist zum Beispiel am optimalen Arbeitspunkt der Stromfluss aus der Solarzelle vom lokalen Serienwiderstandsnetzwerk abhängig. Hingegen fließen bei Leerlaufspannungen keine externen Ströme, allenfalls fließen intern in der Solarzelle Ausgleichströme, insbesondere bei örtlich inhomogenen Verlustmechanismen. Diese internen lateralen Ströme sind üblicherweise verglichen mit Strömen am optimalen Arbeitspunkt der Solarzelle eher klein, so dass bei Leerlaufspannung auch der strombedingte Einfluss beispielsweise des Serienwiderstandsnetzwerkes der Solarzelle auf die ortsaufgelöste Messung vernachlässigbar klein ist. Mit üblichen Messverfahren sind daher durch Messungen bei Leerlaufspannung der Solarzelle keine Aussagen über das Serienwiderstandsnetzwerk der Solarzelle möglich.

Der Erfindung liegt daher die Aufgabe zugrunde, ein Messverfahren und eine Messvorrichtung zur Charakterisierung eines Halbleiterbauelementes zu schaffen, mit dem eine technisch unaufwendigere, schnellere und einfach handhabbare Charakterisierung des Halbleiterbauelementes, insbesondere hinsichtlich des Serienwiderstandsnetzwerkes möglich ist, verglichen mit bekannten Messmethoden. Insbesondere soll auch ohne elektrische Kontaktierung des Halbleiterbauelementes eine Messung möglich sein, bei der das Halbleiterbauelement zumindest in Teilbereichen einen Zustand aufweist, der dem eines elektrisch kontaktierten Halbleiterbauelementes bei Zu- oder Abführung von Ladungsträgern über die elektrische Kontaktierung entspricht, insbesondere der dem Zustand am optimalen Arbeitspunkt des Halbleiterbauelementes entspricht oder zumindest ähnlich ist.

Gelöst ist diese Aufgabe durch ein Messverfahren gemäß Anspruch 1 und eine Messvorrichtung gemäß Anspruch 15. Vorteilhafte Ausgestaltungen des Messverfahrens finden sich in den Ansprüchen 2 bis 14 und der Messvorrichtung in Anspruch 16.

Das erfindungsgemäße Messverfahren dient zur Charakterisierung eines Halbleiterbauelementes mit einer Messfläche, welche die Vorder- und/oder Rückseite des Halbleiterbauelementes ist und mit mindestens einem pn-Übergang. Es umfasst folgende Schritte:

In einem Schritt A wird die Messfläche des Halbleiterbauelementes flächig mit elektromagnetischer Anregungsstrahlung beaufschlagt. Typischerweise wird bei dem erfindungsgemäßen Messverfahren eine zur Lichteinkopplung ausgebildete Vorderseite des Halbleiterbauelementes mit der Anregungsstrahlung beaufschlagt, d. h. vorteilhafterweise ist die Messfläche die Vorderseite des Halbleiterbauelementes, da typischerweise bei Solarzellen die Vorderseite zur Lichteinkopplung ausgebildet ist. Ebenso liegt es jedoch auch im Rahmen der Erfindung, die Rückseite des Halbleiterbauelementes oder sowohl Vorder- als auch die Rückseite mit Anregungsstrahlung zu beaufschlagen, insbesondere bei für beidseitige Lichteinkopplung ausgebildeten Halbleiterbauelementen.

Mittels der elektromagnetischen Anregungsstrahlung, welche in das Halbleiterbauelement eingekoppelt wird, werden Ladungsträgerpaare erzeugt, welche am pn-Übergang des Halbleiterbauelementes getrennt werden.

In einem Schritt B wird von dem Halbleiterbauelement ausgehende elektromagnetische Strahlung mittels mindestens einer Detektionseinheit ortsaufgelöst gemessen.

Ortsaufgelöste Messung bedeutet hierbei, dass für mehrere Teilbereiche und/oder Ortspunkte auf der Solarzelle, vorzugsweise auf der Messseite, jeweils separat eine Messung der von dem Halbleiterbauelement ausgehenden elektromagnetischen Strahlung erfolgt.

Wesentlich ist, dass in Schritt A die Messfläche flächig, jedoch nicht ganzflächig, mit Anregungsstrahlung vorzugsweise mit homogener Intensität beaufschlagt wird. Dies bedeutet, dass mindestens ein vorgegebener Anregungsteilbereich der Messfläche mit einer für diesen Anregungsteilbereich vorgegebenen Intensität der Anregungsstrahlung beaufschlagt wird und mindestens ein weiterer Senkenteilbereich der Messfläche mit einer gegenüber dem Anregungsteilbereich geringeren Intensität der Anregungsstrahlung beaufschlagt wird. Alternativ oder zusätzlich wird zur Erzeugung maximaler Ausgleichströme in mindestens einem vorgegebenen Senkenteilbereich die Intensität 0 vorgegeben, d. h. dieser Teilbereich wird in Schritt A nicht mit Anregungsstrahlung beaufschlagt, so dass in diesem Teilbereich keine Ladungsträgerpaare erzeugt werden. Insbesondere ist es vorteilhaft, dass für sämtliche Senkenteilbereiche aller Schritte A die Intensität 0 vorgegeben ist.

Vorzugsweise wird der Senkenteilbereich gegenüber der den Anregungsteilbereich beleuchtenden Anregungsstrahlung flächig abgeschattet.

Mit dem erfindungsgemäßen Messverfahren ist es somit möglich, das Ausmaß der Trennung von Ladungsträgerpaaren in dem Halbleiterbauelement für jeden der vorgegebenen Teilbereiche gezielt einzurichten. Hierdurch können Stromflussmuster in dem Halbleiterbauelement vorgegeben werden, da typischerweise zwischen einem mit Anregungsstrahlung beaufschlagten Teilbereich (einem Anregungsteilbereich) des Halbleiterbauelementes und einem nicht oder nur geringfügig mit Anregungsstrahlung beaufschlagten Teilbereich (einem Senkenteilbereich) des Halbleiterbauelementes Ausgleichströme fließen, typischerweise Lateralströme, d. h. parallel zu der Vorder- oder Rückseite des Halbleiterbauelementes. Bei dem erfindungsgemäßen Messverfahren werden somit Ströme induziert, welche aus den Anregungsteilbereichen in die Senkenteilbereiche fließen. Das Erzeugen der Stromflussmuster erfolgt über die Anordnung der Anregungs- und Senkenteilbereiche, so dass keine elektrische Kontaktierung des Halbleiterbauelementes zum Erzeugen der Stromflussmuster notwendig ist.

Mit dem erfindungemäßen Messverfahren werden somit durch Vorgabe der Anregungs- und Senkenteilbereiche und zugehörigen Intensitäten der Anregungsstrahlung gezielt Stromflussmuster in dem Halbleiterbauelement erzeugt.

Die elektrische Kontaktierung des fertiggestellten Halbleiterbauelementes erfolgt über eine oder mehrere auf der Vorder- und/oder der Rückseite des Halbleiterbauelementes aufgebrachte Kontaktierungsstrukturen. Die Kontaktierungsstrukturen stellen Stromabflussbereiche oder Stromzuführbereiche dar, welche mit externen Kontaktierungen elektrisch leitend verbindbar sind zum Zu- oder Abführen von Ladungsträgern. Typischerweise sind die Kontaktierungsstrukturen durch Metallisierungen oder hochdotierte Bereiche realisiert und daher niederohmig, insbesondere gegenüber dem Emitter des Halbleiterbauelementes und weisen somit eine höhere Leitfähigkeit auf als dieser.

Ein von einer Kontaktierungsstruktur bedeckter Bereich der Oberfläche des Halbleiterbauelementes wird im Rahmen dieser Anmeldung als Kontaktierungsbereich bezeichnet. Weiterhin werden auch bei noch nicht fertig gestellten Halbleiterbauelementen, bei denen noch keine Kontaktierungsstrukturen aufgebracht wurden, diejenigen Bereiche als Kontaktierungsbereiche bezeichnet, die für das Aufbringen einer Kontaktierungsstruktur vorgesehen sind, d. h. dass die Kontaktierungsbereiche in einem späteren Herstellungsschritt mit einer Kontaktierungsstruktur bedeckt werden.

Bei Solarzellen erfolgt typischerweise die Kontaktierung über eine oder mehrere auf Vorder- und/oder Rückseite des Halbleiterbauelementes aufgebrachte Metallisierungsstrukturen. Vorzugsweise sind die die Kontaktierungsbereiche daher Metallisierungsbereiche, d.h. diejenigen Bereiche der Messfläche, die von einer Metallisierung bedeckt sind oder zur Bedeckung mit einer Metallisierung vorgesehen sind.

Bei dem erfindungsgemäßen Verfahren wird in mindestens einem Schritt A mindestens ein Paar von Anregungs- und Senkenteilbereich auf gegenüberliegenden Seiten eines vorgegebenen Kontaktierungsteilbereiches angeordnet, derart, dass sie an den Kontaktierungsteilbereich zumindest angrenzen oder diesen ganz oder teilweise überlappen.

Der Kontaktierungsteilbereich umfasst hierbei den gesamten Kontaktierungsbereich der Kontaktierungsstruktur oder einen vorgegebenen Teilbereich hiervon.

Dies hat zur Folge, dass ein Stromfluss, ausgehend von dem Anregungsteilbereich in Richtung des Senkenteilbereiches auch vom Anregungsteilbereich in Richtung des Kontaktierungsteilbereiches erfolgt. Dieser Stromfluss entspricht daher einem Stromfluss, bei dem Ladungsträger aus dem Kontaktierungsteilbereich abgezogen werden und somit aus dem Anregungsteilbereich in den Kontaktierungsteilbereich hineinfließen. Hierdurch wird ein Stromflussmuster erzeugt, welches dem des elektrisch kontaktierten Halbleiterbauelementes zumindest für den vorgegebenen Anregungsteilbereich entspricht oder zumindest nahe kommt.

Typische Kontaktierungsstrukturen sind derart ausgebildet, dass die Vorder- und/oder Rückseite des Halbleiterbauelementes durch die Kontaktierungsstrukturen in Segmente aufgeteilt wird. Beispielsweise sind gitterartige oder kammartige Metallisierungsstrukturen bei Solarzellen zur elektrischen Kontaktierung üblich.

Vorzugsweise bildet in einem Schritt A mindestens ein durch die Kontaktierungsstruktur definiertes Segment den Anregungsteilbereich, wobei alle benachbarten, d.h. den das Segment begrenzenden Kontaktierungslinien gegenüber liegenden, Teilbereiche des Halbleiters als Senkenbereiche vorzusehen sind. In mindestens einem Schritt A überdeckt somit mindestens ein Anregungsteilbereich mindestens ein Segment oder mehrere benachbarte Segmente und die zu diesem Anregungsteilbereich benachbarten Segmente sind durch Senkenteilbereiche überdeckt. Zur einfachen Definition der Stromflussmuster und einfacheren Auswertung wird überdeckt vorteilhafterweise der Anregungsteilbereich genau ein Segment.

Hierdurch wird ein Stromflussmuster erzeugt, bei dem aus dem Anregungsteilbereich und damit aus einem oder mehreren benachbarten Segmenten ein Stromfluss in die benachbarten Segmente erfolgt und damit jeweils in Richtung der die Segmente begrenzenden Kontaktierungsteilbereiche. Das sich ergebende Stromflussmuster entspricht für den Anregungsteilbereich, d.h. für ein oder mehrere Segmente, somit dem Zustand bei elektrischer Kontaktierung des Halbleiterbauelementes.

Zusätzlich oder alternativ ist es vorteilhaft, die Segmente wie folgt zu definieren: Vorteilhaftweise ist in mindestens einem Schritt A mindestens ein Anregungsteilbereich, vorzugsweise in allen Schritten A alle Anregungsteilbereiche durch den Rand des Kontaktierungsteilbereiches sowie weiterhin durch weitere Kontaktierungsteilbereiche und/oder weiterhin durch einen oder mehrere Ränder des Halbleiterbauelementes begrenzt. Hierdurch ist gewährleistet, dass der Anregungsteilbereich eine Gesamtfläche umfasst, von der ausgehend Ladungsträger in Richtung der Kontaktierungsteilbereiche im Falle eines kontaktierten Halbleiterbauelementes fließen. Würde der Anregungsteilbereich hingegen nur einen Teil dieser Fläche umfassen, so läge zwischen Anregungsteilbereich und einem Kontaktierungsteilbereich eine Senke vor. Ein solches Stromflussmuster, mit einer Senke zwischen einem Anregungsteilbereich und einem Kontaktierungsteilbereich tritt jedoch typischerweise nicht bei den elektrisch kontaktierten Halbleiterbauelementen auf und stellt somit keinen realistischen Zustand eines elektrisch kontaktierten Halbleiterbauelementes dar.

Vorteilhafterweise weist daher in Schritt A mindestens ein Anregungsteilbereich und vorzugsweise weisen sämtliche Anregungsteilbereiche in sämtlichen Schritten A eine gemeinsame Begrenzung mit einem vorgegebenen Kontaktierungsteilbereich auf, so dass an dieser gemeinsamen Begrenzung insbesondere keine Senke zwischen Anregungsteilbereich und Kontaktierungsteilbereich vorliegt. Vorzugsweise erstreckt sich der Anregungsteilbereich entlang einer Seite des Kontaktierungsteilbereiches. Insbesondere bei langgestreckten oder linienartigen Kontaktierungsteilbereichen ist es vorteilhaft, wenn sich der Anregungsteilbereich entlang einer Längsseite des Kontaktierungsteilbereiches erstreckt, vorzugsweise entlang der gesamten Längsseite.

Weiterhin ist es vorteilhaft, dass in Schritt A mindestens ein Anregungsteilbereich und vorzugsweise sämtliche Anregungsteilbereiche in sämtlichen Schritten A die maximale Ausdehnung aufweisen, die bei Begrenzung durch ein oder mehrere vorgegebene Kontaktierungsteilbereiche und gegebenenfalls einen oder mehrere Ränder des Halbleiterbauelementes möglich ist. Insbesondere ist es vorteilhaft, dass der Anregungsteilbereich die maximale Ausdehnung innerhalb der zu dem Anregungsteilbereich benachbarten Kontaktierungsteilbereiche und gegebenenfalls Rändern des Halbleiterbauelementes aufweist. Zur Vereinfachung der Auswertung der Messungen ist es vorteilhaft, wenn zusätzlich zu vorgenannter Begrenzung der Anregungsteilbereich konvex ist.

Typischerweise reicht eine Kontaktierungsstruktur und entsprechend der zugeordnete Kontaktierungsteilbereich nicht bis unmittelbar an den Rand des Halbleiterbauelementes, sondern weist einen geringfügigen Abstand zu diesem auf. Bezüglich der maximalen Ausdehnung bleibt dieser geringfügige Abstand vorteilhafterweise unberücksichtigt: Die Begrenzung durch die Kontaktierungsteilbereiche wird in dem geringfügigen Abstand zwischen durch eine gedachte Verlängerung der Kontaktierungsteilbereiche bis an den jeweils nächstliegenden Rand und vorzugsweise senkrecht zu diesem, ergänzt. Zusätzlich oder alternativ ist es vorteilhaft, die Anregungsteilbereiche jeweils konvex zu wählen, um etwaige Begrenzungslücken zu schließen.

Weiterhin ist es zusätzlich oder alternativ vorteilhaft, für die Anregungs- und/oder Senkenteilbereiche einfache geometrische Formen vorzugeben, insbesondere eine rechteckige Form. Hierdurch ergibt sich ein geringer apparativer Aufwand bei Erzeugen der jeweiligen Muster und darüber hinaus vereinfacht sich die Auswertung bei Zusammensetzen der einzelnen Messungen zu einem Gesamtbild. Bei dieser vorteilhaften Ausführungsform wird in mindestens einem Schritt A mindestens ein Anregungsteilbereich und vorzugsweise werden sämtliche Anregungsteilbereiche in sämtlichen Schritten A derart gewählt, dass sie bei rechteckiger Form die maximale Fläche innerhalb der Begrenzung durch eine oder mehrere vorgegebene Kontaktierungsteilbereiche und gegebenenfalls die Ränder des Halbleiterbauelementes aufweisen.

Eine Kontaktierungsstruktur eines Halbleiterbauelementes besteht typischerweise aus unterschiedlichen Elementen. Insbesondere bei Solarzellen ist es bekannt, dass eine Kontaktierungsstruktur mindestens einen so genannten Busbar umfasst sowie mehrere mit dem Busbar elektrisch leitend verbundenen Kontaktierungsfinger. Busbar und Kontaktierungsfinger sind typischer als metallische Kontaktierungsstrukturen ausgebildet.

Der Busbar weist eine höhere elektrische Leitfähigkeit gegenüber den Kontaktierungsfingern auf. Dies wird typischerweise dadurch gewährleistet, dass der Busbar eine größere Querschnittsfläche gegenüber den Kontaktierungsfingern und damit einen geringeren elektrischen Widerstand senkrecht zur Querschnittsfläche besitzt. Für das erfindungsgemäße Messverfahren ist es in den meisten Fällen ausreichend, dass die Stromflussmuster eines kontaktierten Halbleiterbauelementes lediglich hinsichtlich der Busbars, nicht jedoch zwingend auch hinsichtlich der Kontaktierungsfinger erzeugt werden. Vorteilhafterweise ist ein Kontaktierungsteilbereich daher derart definiert, dass er lediglich den durch einen Busbar bedeckten Kontaktierungsbereich umfasst. Entsprechend erfolgt auch die zuvor beschriebene Segmentierung ausschließlich durch die Busbars. Typischerweise sind die Busbars linienartig ausgeführt, so dass entsprechend auch die Kontaktierungsteilbereiche vorteilhafterweise linienartig entsprechend den durch die Busbars bedeckten Bereichen definiert sind.

Zur Erzeugung eines Stromflussmusters mit ausreichend starken Strömen zur Erzeugung von gut messbaren Messsignalen ist es vorteilhaft, dass in jedem Schritt A mindestens 0.5 cm$^2$, vorzugsweise mindestens 1 cm$^2$ durch den oder die Anregungsteilbereiche insgesamt abgedeckt ist. Ebenso ist es vorteilhaft, dass in jedem Schritt A ein Sechstel, vorzugsweise ein Viertel der Fläche der Messfläche, insbesondere etwa die Hälfte der Fläche der Messfläche durch den oder die Anregungsteilbereiche abgedeckt ist. Dies führt insbesondere bei typischen Solarzellen mit 2 bis 3 Busbars zu gut messbaren Messsignalen.

Sofern das Halbleiterbauelement mehrere Busbars aufweist bzw. Kontaktierungsteilbereiche, die zur Bedeckung mit Busbars vorgesehen sind, ist es vorteilhaft, dass bei einer Anzahl b von Busbars in jedem Schritt A mindestens ein Teil von 1/(2b), vorzugsweise mindestens ein Teil von 1/b der Fläche der Messfläche durch den oder die Anregungsteilbereiche insgesamt abgedeckt ist, zur Erzeugung ausreichend hoher Ströme und entsprechend ausreichend hoher Messsignale.

Vorzugsweise wird Schritt A mindestens zweimal ausgeführt wird, wobei jeweils eine Messung gemäß Schritt B erfolgt und die Schritte A unterschiedliche Anregungsteilbereiche aufweisen. Es liegt somit bei zwei verschiedenen Schritten A eine Anregung in verschiedenen Anregungsteilbereichen der Messfläche vor.

Die Kombination der in den mindestens zwei Schritten B erfolgten ortsaufgelösten Messungen erlaubt die Erstellung eines Gesamtmessbildes, dass einem Messbild des elektrisch kontaktierten Bauelementes zumindest in den Anregungsteilbereichen gleicht oder nahe kommt.

Vorzugsweise sind die Anregungsteilbereiche derart gewählt, dass sämtliche Anregungsteilbereiche aller Schritte A zusammengenommen zumindest die Messfläche in den Bereichen abdecken, die nicht mit einer Kontaktierungsstruktur bedeckt sind oder die nicht zur Bedeckung mit einer Kontaktierungsstruktur vorgesehen sind.

Nach Durchführung aller Schritte A sind somit zumindest sämtliche Bereiche der Messfläche, die nicht mit einer Kontaktierungsstruktur bedeckt sind oder nicht zur Bedeckung mit einer Kontaktierungsstruktur vorgesehen sind, mindestens einmal mit Anregungsstrahlung der für die Anregungsteilbereiche vorgegebenen Intensität beaufschlagt worden. Hierdurch ist es möglich, durch Zusammenführen aller Messungen ein Gesamtmessbild zu erhalten, bei dem die gesamte Messfläche (gegebenenfalls mit den genannten Einschränkungen hinsichtlich der Kontaktierungsbereiche) mit Anregungsstrahlung der für die Anregungsteilbereiche vorgegebenen Intensität beaufschlagt wurde und gleichzeitig dem Gesamtmessbild ein Stromflussmuster zugrunde liegt, das durch die in den jeweiligen Schritten A vorgegebene Kombination von Anregungsteilbereichen und Senkenteilbereichen gewählt wurde. Dies ermöglicht insbesondere die kontaktlose Charakterisierung des Halbleiterbauelementes unter Erzeugung von Stromflussmustern, welche denen eines elektronisch kontaktierten Bauelementes entsprechen. Vorteilhafterweise wird das erfindungsgemäße Verfahren daher ohne eine elektrische Kontaktierung des Halbleiterbauelementes durchgeführt, zur Beschleunigung und Vereinfachung des Messverfahrens.

Daher ist das erfindungsgemäße Verfahren insbesondere für die Charakterisierung von Halbleiter-Solarzellen, bzw. Vorstufen dieser Solarzellen im Herstellungsprozess geeignet, sofern die Vorstufe bereits mindestens einen pn-Übergang aufweist. Ebenso ist das Verfahren jedoch auch zur Charakterisierung anderer Halbleiterbauelemente geeignet, insbesondere bei solchen Halbleiterbauelementen, die mindestens einen flächigen pn-Übergang aufweisen, der zumindest teilweise in etwa parallel zur Vorder- oder Rückseite verläuft.

Die Schritte A und B werden typischerweise gleichzeitig ausgeführt, d.h. während des Beaufschlagens des Halbleiterbauelementes mit Anregungsstrahlung wird gleichzeitig die ortsaufgelöste Messung vorgenommen. Es liegt jedoch auch im Rahmen der Erfindung, die Schritte A und B hintereinander auszuführen. Ebenso liegt es im Rahmen der Erfindung, während einer andauernden Messung (Schritt B) eine pulsierendes Beaufschlagen des Halbleiterelementes mit Anregungsstrahlung (Schritt A) gemäß einer vorgegebenen Beaufschlagungsfrequenz vorzunehmen, um eine Messung in dem an sich bekannten Lock-In-Verfahren vorzunehmen, bei dem solche Messsignale ausgefiltert werden, die eine von der Beaufschlagungsfrequenz abweichende Frequenz aufweisen.

Die ortsaufgelöste Messung erfolgt in Schritt B vorteilhafterweise zumindest in den Anregungsteilbereichen des zugehörigen Schrittes A, vorzugsweise erfolgt in Schritt B eine ortsaufgelöste Messung der gesamte Messfläche oder der gesamten Vorder- und/oder Rückseite des Halbleiterbauelementes. Ebenso liegt es im Rahmen der Erfindung, in Schritt B lediglich die Senkenteilbereiche des zugehörigen Schrittes A ortsaufgelöst zu vermessen. Dies ist insbesondere dann vorteilhaft, wenn das erfindungsgemäße Verfahren für großflächig emittierende Dioden verwendet wird, da bei solchen Halbleiterbauelementen typischerweise die Charakterisierung von Senkenteilbereichen wesentlich ist.

Vorteilhafterweise wird das Halbleiterbauelement bei allen Schritten A in allen Anregungsteilbereichen mit Anregungsstrahlung eines identischen Spektrums beleuchtet und zwischen den Anregungs- und Senkenteilbereichen lediglich die Intensität variiert, da insbesondere eine Intensitätsänderung der Anregungsstrahlung in einfacher und kostengünstiger Weise durch optische Filter oder Blenden durchführbar ist.

Zur Erzeugung einheitlicher Messbedingungen ist vorteilhafterweise für alle Schritte A für alle Anregungsteilbereiche eine identische Intensität der Anregungsstrahlung vorgegeben und/oder für alle Schritte A für alle Senkenteilbereiche eine identische Intensität der Anregungsstrahlung vorgegeben.

Zur Erzeugung ausreichend hoher Ausgleichströme zwischen Anregungs- und Senkenteilbereichen ist es vorteilhaft, wenn die Intensität der Anregungsstrahlung in den Senkenteilbereichen mindestens um einen Faktor 10, vorzugsweise um einen Faktor 100, im weiteren vorzugsweise um einen Faktor 1000 geringer ist als in den Anregungsteilbereichen.

Weiterhin werden die Anregungs- und Senkenteilbereiche vorteilhafterweise derart gewählt, dass die resultierenden Stromflussmuster in den Anregungsteilbereichen in etwa den Stromflussmustern bei Stromentnahme oder Strominjektion über eine elektrische Kontaktierung entsprechen, vorzugsweise dem Zustand des Halbleiterbauelementes am optimalen Arbeitspunkt.

Um in Schritt A einen klar definierten Zustand des Halbleiterbauelementes zu erwirken, ist es vorteilhaft, dass in jedem Schritt A Anregungsteilbereiche und Senkenteilbereiche zusammengenommen zumindest die Messfläche in den Bereichen abdecken, die nicht mit einer Kontaktierungsstruktur bedeckt sind oder die nicht zur Bedeckung mit einer Kontaktierungsstruktur vorgesehen sind.

Wie vorhergehend beschrieben, weist das erfindungsgemäße Verfahren den Vorteil auf, dass durch Zusammensetzen aller Messungen ein Bild entsteht, bei dem sämtliche Bereiche der Messfläche (gegebenenfalls unter Ausschluss der Kontaktierungsbereiche) mindestens einmal mit Anregungsstrahlung gemäß der für die Anregungsteilbereiche vorgegebenen Intensität beaufschlagt wurden. Zur Vermeidung mehrfacher Messsignale aus identischen Bereichen ist es vorteilhaft, dass die Anregungsteilbereiche aller Schritte A disjunkt, insbesondere paarweise disjunkt sind. Dies bedeutet, dass alle Anregungsteilbereiche zusammengenommen keine Überlappung aufweisen und somit keine mehrfache Beaufschlagung eines Bereiches der Messfläche mit Anregungsstrahlung der für die Anregungsteilbereiche vorgegebenen Intensität erfolgt.

Wie vorhergehend beschrieben, erfolgt bei dem erfindungsgemäßen Verfahren eine Erzeugung vorgegebener Stromflussmuster durch die vorgegebene Anordnung der Anregungs- und Senkenteilbereiche. Zur Erzeugung einfach nachvollziehbarer Stromflussmuster und zur einfacheren Zusammensetzung eines Gesamtbildes aus den Einzelmessungen ist es vorteilhaft, dass in mindestens einem Schritt A, vorzugsweise in allen Schritten A, jeder Anregungsteilbereich konvex ist.

In einer vorteilhaften Ausgestaltung des erfindungsgemäßen Messverfahrens werden die Schritte A und B mindestens zweimal ausgeführt, so dass eine erste und mindestens zweite ortsaufgelöste Messung der von dem Halbleiterbauelement ausgehenden elektromagnetischen Strahlung erfolgt. Hierbei sind bei der ersten Messung andere Anregungsteilbereiche und/oder andere Intensitäten der Anregungsstrahlung vorgegeben, gegenüber der zweiten Messung. Weiterhin ist es vorteilhaft, dass bei mindestens einer Messung in einem Schritt A' die Messfläche des Halbleiterbauelementes ganzflächig und hinsichtlich der Strahlungsintensität homogen mit Anregungsstrahlung beaufschlagt wird.

In dieser vorteilhaften Ausgestaltung stehen somit mehrere ortsaufgelöste Messbilder der von dem Halbleiterbauelement ausgehenden elektromagnetischen Strahlung zur Verfügung, bei denen unterschiedliche Teilbereiche mit Anregungsstrahlung beaufschlagt wurden bzw. die gesamte Messfläche des Halbleiterbauelementes homogen mit Anregungsstrahlung beaufschlagt wurde. Eine Kombination dieser Messdaten erlaubt den quantitativen Rückschluss auf physikalische Parameter des Halbleiterbauelementes, insbesondere auf örtlich inhomogen verteilte Serienwiderstände. Die Messung mit ganzflächiger Beleuchtung der Messfläche dient hierbei als Referenz, wobei ein aus den Messungen bei Beaufschlagung der Anregungsteilbereiche mit Anregungsstrahlung zusammengesetztes Gesamtmessbild in ein Verhältnis zu der Referenz gesetzt wird. Dies erfolgt beispielsweise bei Messung der Lumineszenzstrahlung vorzugsweise durch Division der Messwerte von Gesamtmessbild und Referenz (jeweils für jeden Ortspunkt der Messung) und bei Messung der Wärmestrahlung mittels Thermographie vorzugsweise durch Subtraktion der Messwerte von Gesamtmessbild und Referenz (jeweils für jeden Ortspunkt der Messung).

Vorteilhafterweise werden in zwei Messungen verschiedene Teilbereiche mit Anregungsstrahlung beaufschlagt und in einer dritten Messung wird die Messfläche wie beschrieben ganzflächig und homogen mit Anregungsstrahlung beaufschlagt. In einem anschließenden Auswerteschritt werden die ortsaufgelösten Messungen aus den drei Messungen für jeden Ortspunkt mittels vorgegebener Berechnungsmethoden verrechnet, sodass sich für jeden Ortspunkt ein ausgewertetes Messergebnis ergibt.

Untersuchungen der Anmelderin haben ergeben, dass bei der Messung von Lumineszenzstrahlung vorteilhafterweise die Berechnungsmethode gemäß Formel 1 vorgegeben wird:

$$ME_i = \ln(M1_i + M2_i) - \ln(M3_i) \, ; \quad \forall i\,(1,...,n) \qquad (\text{Formel } 1)$$

d.h. bei insgesamt $n$ Messpunkten wird das Messergebnis $ME_i$ für jeden Ortspunkt $i$ gemäß Formel 1 abhängig von den Messwerten für den Ortspunkt $i$ aus der ersten Messung $M1_i$, aus der zweiten Messung $M2_i$, und aus der dritten Messung $M3_i$ bestimmt.

Für jeden Messpunkt wird somit die Differenz hinsichtlich der Intensität aus den ersten beiden Messungen gebildet, wobei das Basisniveau der von dem Halbleiterbauelement ausgehenden elektromagnetischer Strahlung, welches bei homogener ganzflächiger Beleuchtung vorliegt, durch Subtraktion der dritten Messung eliminiert wird. Im Ergebnis liegen somit ortsaufgelöste Daten der durch das Stromflussmuster bedingten lateralen Signalverteilung vor, so dass insbesondere Rückschlüsse hinsichtlich der Serienwiderstandsverteilung in dem Halbleiterbauelement möglich sind.

Vorteilhafterweise werden die Teilbereiche in den ersten beiden Messungen derart vorgegeben, dass das Stromflussmuster auf dem beleuchteten Teil mit dem Stromflussmuster bei Entnahme von Strom an den elektrischen Kontakten der Solarzelle ähnlich ist. Vorteilhafterweise wird hierbei ein Stromflussmuster erzeugt, welches dem normalem Betrieb am optimalen Arbeitspunkt ähnlich ist, insbesondere, dass die Stromflüsse in dem Halbleiterbauelement in Richtung der elektrischen Kontaktierungen, vorzugsweise der Busbars, des Halbleiterbauelementes fließen.

Typische Solarzellen weisen an der zur Lichteinkopplung ausgebildeten Vorderseite eine gitterartige Metallstruktur auf, wobei Metallisierungslinien in etwa parallel über die Vorderseite der Solarzelle verlaufen (die bereits beschriebenen Busbars), von denen ausgehend dem gegenüber dünnere Metallisierungsfinger meist senkrecht zu den Busbars verlaufen.

Vorteilhafterweise werden die Senkenteilbereiche derart gewählt, dass die Grenzen der Senkenteilbereiche in etwa den Busbars bzw. den Rändern des Halbleiterbauelementes entsprechen.

In einer bevorzugten Ausführungsform des erfindungsgemäßen Verfahrens wird daher zur Charakterisierung einer solchen Solarzelle mit beispielsweise zwei Busbars bei der ersten ortsaufgelösten Messung die Solarzelle in einem ersten Anregungsteilbereich, der zwischen zwei benachbarten Busbars liegt und durch diese sowie den Rand der Solarzelle begrenzt wird, mit Anregungsstrahlung beaufschlagt und die übrigen Teilbereiche werden als Senkenteilbereiche nicht oder nur mit dem gegenüber geringerer Intensität der Anregungsstrahlung beaufschlagt.

Bei der zweiten ortsaufgelösten Messung werden umgekehrt die übrigen Teilbereiche als Anregungsteilbereiche mit Anregungsstrahlung beaufschlagt und der erste Teilbereich wird als Senkenteilbereich nicht oder nur mit geringer Intensität verglichen mit den übrigen Teilbereichen mit Anregungsstrahlung beaufschlagt.

Bei der ersten ortsaufgelösten Messung werden somit im Wesentlichen in dem Teilbereich zwischen den Busbars Ladungsträger erzeugt. Dies führt zu einem Stromfluss zu dem nicht beleuchteten Teilbereich, da dort der wesentliche Anteil der Rekombination der erzeugten Ladungsträger stattfindet. Durch diese Anordnung ist bei der ersten Messung somit ein Stromflussmuster im Teilbereich zwischen den Busbars zu den Busbars hin erzeugt, da von dem ersten Teilbereich aus gesehen, die nicht oder nur geringfügig beleuchteten Teilbereiche hinter den Busbars liegen.

Dies bedeutet, dass ein ähnliches Stromflussmuster vorliegt, als würde an den Busbars eine Kontaktierung der Solarzelle stattfinden und Ladungsträger von den Busbars abgegriffen werden.

Der entscheidende Vorteil ist somit, dass ein Stromflussmuster vergleichbar mit dem einer kontaktierten Solarzelle erzeugt wird, ohne dass die Solarzelle hierzu kontaktiert werden müsste. Dies ermöglicht die kontaktlose Vermessung einer Solarzelle, so dass erheblich kürzere Messzeiten und ein erheblich geringerer technischer Aufwand zur Vermessung der Solarzelle notwendig ist und darüber hinaus bei der Messung keine mechanische Belastung der Solarzelle durch eine elektrische Kontaktierung erfolgt.

Entsprechendes gilt für die zweite ortsaufgelöste Messung: Hier stellt der Bereich zwischen den Busbars den nicht oder nur geringfügig beleuchteten Teilbereich dar, so dass die in den übrigen Teilbereichen der Solarzelle mittels der Anregungsstrahlung getrennten Ladungsträgerpaare zu dem ersten Teilbereich hinfließen, d. h. insbesondere zu den Busbars hinfließen, allerdings diesmal von der anderen Seite aus, verglichen mit der ersten ortsaufgelösten Messung.

In der zweiten ortsaufgelösten Messung ist somit in den übrigen Teilbereichen ein Stromflussmuster erzeugt, als wäre die Solarzelle an den Busbars kontaktiert und von diesen würden Ladungsträger abgegriffen werden.

Die Kombination der ortsaufgelösten ersten und zweiten Messung ergibt somit ein Stromflussbild der gesamten Solarzelle, als wäre diese an den Busbars kontaktiert.

Die Berücksichtigung der dritten ortsaufgelösten Messung bei ganzflächiger homogener Beaufschlagung der Solarzelle mit Anregungsstrahlung dient lediglich dazu, die grundsätzlich bei Beaufschlagung der Solarzelle von der Solarzelle ausgehende elektromagnetische Strahlung, welche nicht durch die zu den Metallisierungslinien hinführende Ströme erzeugt wird, als Referenzpunkt zu berücksichtigen, so dass eine einfachere und genauere Auswertung möglich ist.

In einer vorteilhaften Ausgestaltung des erfindungsgemäßen Messverfahrens wird das Halbleiterbauelement dadurch in den vorgegeben Teilbereichen mit vorgegebener Intensität und/oder vorgegebenem Spektrum der Anregungsstrahlung beaufschlagt, dass in den Strahlengang einer die Anregungsstrahlung erzeugenden Strahlungsquelle zwischen Halbleiterbauelement und Strahlungsquelle optische Filter angeordnet werden.

Vorteilhafterweise ist die Strahlungsquelle derart ausgeführt, dass sie ohne Zwischenschaltung optischer Filter das Halbleiterbauelement ganzflächig homogen mit Anregungsstrahlung beaufschlagt. Durch gezielte Anordnung und/gezielte Ausgestaltung der optischen Filter wird die vorgegebene Beaufschlagung des Halbleiterbauelementes in den vorgegebenen Teilbereichen erreicht. Insbesondere ist es vorteilhaft, die optischen Filter als Abschattungsmasken aufzugestalten, welche einen vorgegebenen Absorptionsgrad hinsichtlich der Anregungsstrahlung aufweisen.

Vorteilhafterweise erfolgt in Schritt B die Messung von dem Halbleiterbauelement ausgehender elektromagnetischer Strahlung (Rückstrahlung) kontaktlos. Insbesondere ist es bei Halbleiterbauelementen mit elektrischen Kontakten vorteilhaft, dass wie zuvor beschrieben die elektrischen Kontakte des Halbleiterbauelementes nicht kontaktiert sind.

Eine kontaktlose Messung von dem Halbleiterbauelement ausgehender elektromagnetischer Strahlung ist insbesondere mit einem Photolumineszenz-Messverfahren vorteilhaft. Dieses Photolumineszenz-Messverfahren ist zur Charakterisierung von Solarzellen an sich bekannt und wird beispielsweise in T. Trupke, E. Pink, R.A. Bardos, and M.D. Abbott, "Spatially resolved series resistance of silicon solar cells obtained from luminescence imaging", Applied Physics Letters 90, 093506 (2007) beschrieben. Der Inhalt dieser Veröffentlichung wird durch Bezugnahme vollumfänglich in die Beschreibung aufgenommen.

Ebenso ist es vorteilhaft, anstelle der bei Rekombinationsvorgängen ausgesandten Photolumineszenz-Strahlung die thermische Abstrahlung des Halbleiterbauelementes ortsaufgelöst zu vermessen. In einer weiteren vorteilhaften Ausgestaltung wird die ortsaufgelöste Messung in Schritt B daher mittels des ILIT-Verfahrens ("Illuminated Lock-In Thermography") durchgeführt. Dieses ILIT-Verfahren ist zur Charakterisierung von Solarzellen an sich bekannt und wird unter anderem in J. Isenberg, W. Warta, J. Appl. Phys. 95(9) 5200 (2004) beschrieben. Der Inhalt dieser Veröffentlichung wird durch Bezugnahme vollumfänglich in die Beschreibung aufgenommen.

Die Erfindung betrifft ferner eine Messvorrichtung für ein Halbleiterbauelement mit einer Vorder- und Rückseite. Die Messvorrichtung umfasst eine Strahlungsquelle zur flächigen Beaufschlagung der Vorder- und/oder Rückseite des Halbleiterbauelementes mit Anregungsstrahlung sowie mindestens eine Detektionseinheit, zur ortsaufgelösten Messung von dem Halbleiterbauelement ausgehender elektromagnetischer Strahlung.

Wesentlich ist, dass die Messvorrichtung weiterhin eine Modifikationseinheit umfasst, welche im Strahlengang der Strahlenquelle zwischen Halbleiterbauelement und Strahlungsquelle angeordnet ist. Die Modifikationseinheit umfasst mindestens einen optischen Filter, welcher wahlweise in dem Strahlengang zwischen Strahlungsquelle und Halbleiterbauelement anordbar ist. Mittels des optischen Filters ist der Strahl der Strahlungsquelle in vorgegebenen Teilbereichen hinsichtlich der Intensität und/oder der spektralen Zusammensetzung beeinflussbar.

Durch das wahlweise Anordnen des optischen Filters im Strahlengang zwischen Strahlungsquelle und Solarzelle ist es somit möglich, in vorgegebenen Teilbereichen den Strahl des Halbleiterbauelementes hinsichtlich der Intensität und/oder der spektralen Zusammensetzung zu beeinflussen, so dass der Strahl der Strahlungsquelle derart beeinflussbar ist, dass ein Messverfahren gemäß Anspruch 1 durchführbar ist, d. h. dass insbesondere das Halbleiterbauelement nicht ganzflächig homogen mit der durch die Strahlungsquelle erzeugten Anregungsstrahlung beaufschlagt wird, sondern mittels der wahlweise anordbaren optischen Filter verschiedene vorgegebene Teilbereiche des Halbleiterbauelementes mit einer für jeden Teilbereich vorgegebenen Intensität und/oder spektralen Zusammensetzung der Anregungsstrahlung beaufschlagt werden.

Vorteilhafterweise ist der optische Filter als Abschattungsmaske ausgebildet, welche den Strahl der Strahlungsquelle in mindestens einem vorgegebenen Teilbereich hinsichtlich der Intensität um einen vorgegebenen Faktor verringert, vorzugsweise um einen Faktor 10, insbesondere einen Faktor 100. Insbesondere ist es vorteilhaft, den optischen Filter als Blende auszugestalten, d. h. das der optische Filter die Anregungsstrahlung vollständig absorbiert und/oder reflektiert.

In einer vorteilhaften Ausgestaltung der erfindungsgemäßen Messvorrichtung umfasst die Modifikationseinheit eine Verschiebevorrichtung, mittels derer der optische Filter senkrecht zur Hauptachse des Strahls der Strahlungsquelle verschiebbar ist, so dass er wahlweise einen vorgegebenen Teitbereich des Halbleiterbauelementes von der Strahlungsquelle abschattet.

In einer weiteren vorteilhaften Ausgestaltung der erfindungemäßen Messvorrichtung umfasst die Modifikationseinheit eine Halterung, an der mindestens ein optischer Filter schwenkbar angeordnet ist. Der Filter ist dabei derart angeordnet, dass er wahlweise in eine Stellung parallel oder eine Stellung senkrecht zur Hauptachse des Strahls der Strahlungsquelle schwenkbar ist.

In der Stellung parallel zur Hauptachse des Strahls der Strahlungsquelle wird der Strahl somit nur vernachlässigbar gering durch den optischen Filter beeinflusst. Vorzugsweise ist der optische Filter hierzu flächig mit einer geringen Dicke kleiner 5mm, insbesondere kleiner 3mm ausgeführt.

Wird der Filter hingegen in die Stellung senkrecht zur Hauptachse des Strahls der Strahlungsquelle geschwenkt, so beeinflusst er den Strahl der Strahlungsquelle in den vorgegebenen Teilbereichen und entsprechend wird auch das Halbleiterbauelement bei Stellung des Filters senkrecht zur Hauptachse des Strahls nur in den vorgegebenen Teilbereichen mit Anregungsstrahlung beaufschlagt, bzw. mit Anregungsstrahlung in vorgegebener Intensität und/oder spektralen Zusammensetzung.

Vorteilhafterweise umfasst die Modifikationseinheit eine Schwenkvorrichtung, welche mit dem optischen Filter in Wirkverbindung steht, derart, dass der optische Filter relativ zur Hauptachse des Strahls der Strahlungsquelle mittels der Schwenkvorrichtung wahlweise schwenkbar ist. Insbesondere ist es vorteilhaft, die Schwenkvorrichtung als elektrische Schwenkvorrichtung auszuführen, welche mittels elektrischer Steuersignale steuerbar ist, so dass die Ausrichtung des optischen Filters mittels elektrischer Steuersignale vorgebbar ist.

In einer weiteren vorteilhaften Ausgestaltung umfasst die erfindungsgemäße Messvorrichtung mindestens einen zweiten optischen Filter und eine zweite Schwenkvorrichtung, wobei die optischen Filter unabhängig voneinander mittels der jeweils zugeordneten Schwenkvorrichtung schwenkbar sind.

In einer weiteren vorteilhaften Ausgestaltung umfasst die erfindungsgemäße Messvorrichtung mindestens einen optischen Filter und eine damit zusammenwirkende Verschiebeeinheit. Die Verschiebeeinheit ist derart ausgeführt, dass der optische Filter im Wesentlichen senkrecht zu der Hauptachse des Strahls der Strahlungsquelle verschiebbar ist. Der Filter kann somit mittels der Verschiebeeinheit durch den Strahl der Strahlungsquelle hindurchgeschoben werden, so dass ein wandernder Schatten des Filters auf dem zu vermessenden Halbleiterbauelement entsteht und somit das Halbleiterbauelement während des Verschiebens des Filters teilweise abgeschattet wird, wobei sich die Abschattungsbereiche mit Verschieben des Filters ändern.

In einer weiteren vorteilhaften Ausführung sind die Modifikationseinheit und Strahlungsquelle in einem Gerät integriert, wobei die Modifikationseinheit derart ausgeführt ist, dass mittels eines Computers die Teilbereiche des Halbleiterelementes vorgebbar sind, die mit Anregungstrahlung der Strahlungsquelle beaufschlagt werden. Insbesondere ist es vorteilhaft, die Strahlungsquelle und die Modifikationseinheit als handelsüblichen Videoprojektor ("Beamer") auszuführen.

Die erfindungsgemäße Messvorrichtung und auch das erfindungsgemäße Messverfahren eignen sich insbesondere zur Charakterisierung von Solarzellen oder Vorstufen von Solarzellen im Herstellungsprozess, bei denen auf der Vorder- oder Rückseite mindestens eine Metallisierungslinie ausgebildet ist. Diese Metallisierungslinien werden auch "busbars" genannt, wie vorhergehend bereits beschrieben. In den Bereichen, in denen die Oberfläche der Solarzelle mit der Metallisierungslinie bedeckt ist, ist keine direkte Einkopplung von elektromagnetischer Strahlung in die Solarzelle möglich, da die Strahlung typischerweise von der Metallisierungslinie reflektiert und/oder absorbiert wird.

Vorteilhafterweise ist der optische Filter daher derart an der Modifikationseinheit angeordnet, dass bei Ausrichtung des optischen Filters parallel zur Hauptachse des Strahls der Strahlungsquelle die verbleibende Abschattung durch diesen Filter in etwa einen Teilbereich des Strahls der Strahlungsquelle betrifft, welcher der linienartigen Metallisierungslinie zugeordnet ist.

Der optische Filter ist somit derart angeordnet, dass bei paralleler Stellung zur Hauptachse des Strahls der Strahlungsquelle der verbleibende Schatten des optischen Filters somit in etwa auf die Metallisierungslinie fällt, so dass alle relevanten Teilbereiche der Solarzelle bei dieser Ausrichtung des optischen Filters mit Anregungsstrahlung beaufschlagt werden.

Die Art der in Schritt B detektierten elektromagnetischen Strahlung und entsprechend die Ausgestaltung der Detektionseinheit kann je nach gewünschtem Messprinzip variieren. So ist es bekannt, dass beispielsweise die Band-zu-Band Rekombination von Ladungsträgern in dem Halbleiterbauelement typischerweise unter Lichtaussendung stattfindet. In einem so genannten Photolumineszenz (PL) Verfahren wird dieser Umstand zur ortsaufgelösten Messung benutzt. Ebenso sind Thermografie-Messverfahren bekannt, welche mittels einer Wärmekamera durch ortsaufgelöste Messung der lokalen Wärmeabstrahlung die durch elektrische Stromflüsse verursachte laterale Wärmeaufteilung in dem Halbleiterbauelement ortsaufgelöst detektieren. Ebenso liegt es im Rahmen der Erfindung, andere ortsaufgelöste Messungen für entsprechende ausgehende elektromagnetische Strahlung in Schritt B zu verwenden.

Weitere Merkmale und vorteilhafte Ausgestaltungen des erfindungemäßen Verfahrens werden im Folgenden anhand der Figur beschrieben. Dabei zeigt:

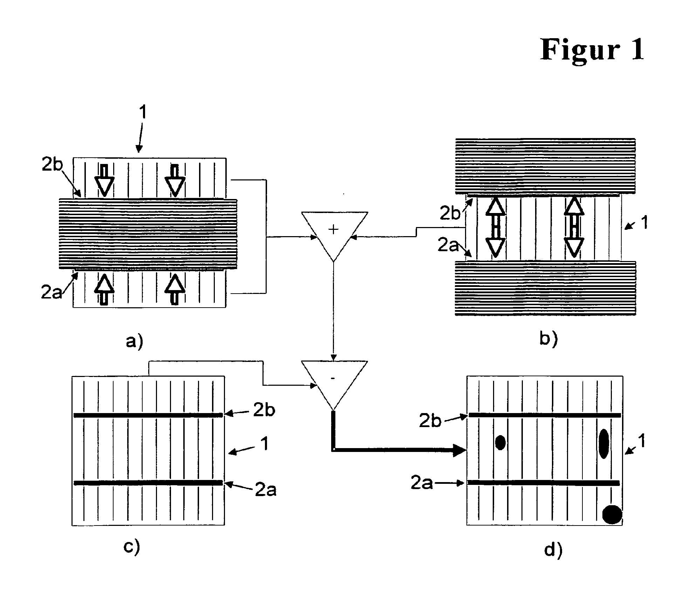

Figur 1    eine schematische Darstellung des Ablaufs eines Ausführungsbeispiels des erfindungsgemäßen Messverfahrens.

Figur 1 zeigt die Anwendung eines Ausführungsbeispiels des erfindungsgemäßen Messverfahrens zur Vermessung eines Halbleiterbauelementes 1, welches als Solarzelle ausgeführt ist, mit zwei parallel zueinander laufenden Metallisierungslinien 2a und 2b, welche die Busbars der Metallisierungsstruktur sind.

Für die Messung wird eine herkömmliche Photolumineszenz-Messvorrichtung verwendet, welche um eine Modifikationseinheit mit zwei optischen Filtern erweitert wurde.

Die Zelle wird bei der Messung nicht elektrisch kontaktiert. Insgesamt werden drei Messungen durchgeführt, wobei bei jeder Messung eine Aufnahme mit der Kamera der Messvorrichtung mit einer Messzeit von je einer Sekunde durchgeführt werden. Die drei Messungen unterscheiden sich nur durch unterschiedliche Abschattungsbedingungen hinsichtlich der Anregungsstrahlung. Die Messfläche ist hierbei die in den Figuren 1 a, b, c, d jeweils dargestellte Vorderseite der Solarzelle.

In einer ersten Messung (Figur 1a) wird in einem ersten Schritt A derjenige Teilbereich, der durch die Metallisierungslinien 2a und 2b sowie die Ränder der Solarzelle begrenzt ist als Senkenteilbereich mittels der optischen Filter abgeschattet (durch die quergestreifte Markierung dargestellt), so dass lediglich ein Teilbereich ausgehend von der Metallisierungslinie 2b bis zum oberen Rand der Solarzelle und ein Teilbereich ausgehend von der Metallisierungslinie 2a bis zum unteren Rand der Solarzelle als Anregungsteilbereiche mit Anregungsstrahlung beaufschlagt werden.

Entsprechend tritt auch nur in den beiden letztgenannten Teilbereichen der Solarzelle eine signifikante Trennung von Ladungsträgern aufgrund der eingekoppelten Anregungsstrahlung auf, so dass aus diesen Bereichen in der Solarzelle laterale Stromflüsse in Richtung der Metallisierungslinien 2a und 2b entstehen, welche durch die Pfeile auf der Solarzelle in Figur 1 angedeutet sind.

Wie vorhergehend beschrieben, werden hierdurch Stromflussmuster erzeugt, die einer kontaktierten Solarzelle entsprechen, bei der durch elektrische Kontaktierung der Metallisierungslinien 2a und 2b Ladungsträger von diesen Metallisierungslinien in einen externen Stromkreis abgeführt werden und dementsprechend in der Solarzelle laterale Stromflüsse zu den Metallisierungslinien hin entstehen.

In einer zweiten Messung (Figur 1 b) wird ein Messbild mit invertierter Beleuchtung aufgenommen, d. h. in einem zweiten Schritt A werden die beiden äußeren Teilbereiche als Senkenteilbereiche werden abgeschattet (durch die quergestreifte Markierung gekennzeichnet) und der mittige Teilbereich, welcher durch die Metallisierungslinien 2a und 2b, sowie den rechten und den linke Rand der Solarzelle begrenzt ist, wird als Anregungsteilbereich mit Anregungsstrahlung beaufschlagt.

Auch hier tritt der Effekt auf, dass in der Solarzelle laterale Ströme in Richtung der Metallisierungslinien 2a und 2b entstehen und somit der Zustand einer elektrisch kontaktierten Solarzelle für den mittleren Teilbereich der Solarzelle simuliert wird.

Bei diesem Ausführungsbeispiel sind somit die Kontaktierungsteilbereiche wie vorhergehend beschrieben lediglich als diejenigen Bereiche definiert, welche durch die Busbars, nicht jedoch durch die Metallisierungsfinger bedeckt sind. Weiterhin ist die Messfläche durch die Kontaktierungsteilbereiche Segmentiert und in jedem Schritt A überdecken jeder Anregungsteilbereiche jeweils ein Segment, wobei die jeweils angrenzenden Segmente durch Senkenteilbereiche überdeckt sind.

Weiterhin sind bei diesem Ausführungsbeispiel die Anregungs- und Senkenteilbereiche jeweils durch die Ränder der Solarzelle und die Kontaktierungsteilbereiche begrenzt und besitzen jeweils die maximale Ausdehnung innerhalb dieser Grenzen. Bezüglich der maximalen Ausdehnung bleibt unberücksichtigt, dass die Busbars nicht bis unmittelbar an die Ränder der Solarzelle heranreichen, sondern einen geringfügigen Abstand zu diesen Aufweisen. Die Begrenzung durch die Kontaktierungsteilbereiche wird in dem geringfügigen Abstand zwischen den Enden der Busbars und den Solarzellenrändern durch eine gedachte Verlängerung der Kontaktierungsteilbereiche bis an die Solarzellenränder ergänzt.

Bei der ersten und zweiten Messung wird jeweils mittels der Kamera der Messvorrichtung ein ortsaufgelöstes Bild der Photolumineszenz-Strahlung aufgenommen.

In einer dritten Messung (Figur 1c) wird in einem Schritt A' die gesamte Solarzelle mit Anregungsstrahlung beaufschlagt, ohne dass eine Abschattung der Anregungsstrahlung stattfindet.

Diese drei Messbilder werden gemäß der oben angegebenen Formel 1 für jeden Messpunkt in einem Auswerteschritt miteinander verrechnet: Die ersten beiden Messbilder werden hinsichtlich der Messintensität addiert (durch das Dreieckssymbol mit "+") gekennzeichnet, so dass sich ein ortsaufgelöstes Messbild der gesamten Solarzelle mit Stromflussmustern jeweils zu den Metallisierungslinien 2a und 2b hin ergibt. Das ortsaufgelöste Messbild der dritten Messung wird für jeden Ortspunkt subtrahiert (Dreieckssymbol mit "-"), wobei hier gemäß Formel 1 die logarithmischen Messwerte verwendet werden.

Es ergibt sich das in Figur 1d) dargestellte Serienwiderstandsbild, in dem etwaige vorhandene lokal erhöhte Serienwiderstände erkennbar sind, wie beispielsweise schematisch in Figur 1d) durch die drei Ellipsen dargestellt.

Mit dem erfindungsgemäßen Messverfahren ist es somit erstmals möglich, bei einer elektrisch nicht kontaktierten Solarzelle Messungen unter Bedingungen vorzunehmen, die einer an einen externen Stromkreis angeschlossenen Solarzelle unter Abführung von Ladungsträgern insbesondere von den Metallisierungslinien der Solarzelle entsprechen.

Hierdurch lassen sich in kostengünstiger und schneller Weise ortsaufgelöste Messungen zur Charakterisierung der Solarzelle durchführen. Somit ist das erfindungsgemäße Messverfahren und die erfindungsgemäße Messvorrichtung insbesondere für den Inline-Betrieb geeignet, d. h. zur fortwährenden Charakterisierung der in einer Produktionsstraße hergestellten Solarzellen, ohne dass die zu vermessende Solarzelle hierfür aus dem Produktionsfluss herausgenommen werden müsste. Insbesondere entfällt das aufwendige und mit einer hohen Fehleranfälligkeit behaftete elektrische Kontaktieren der Solarzelle zur Vermessung.

**Patentansprüche**

1. Messverfahren zur Charakterisierung eines Halbleiterbauelementes (1) mit mindestens einem pn-Übergäng und einer Messfläche, welche die Vorder- und/oder Rückseite des Halbieiterbauelementes ist und welche mindestens einen Kontaktietungsteilbereich aufweist, der mit einer Kontaktierungsstruktur bedeckt ist öder zur Bedeckung mit einer Kontaktierungsstruktur vorgesehen ist, folgende Schritte umfassend:

   A Flächiges Beaufschlagen der Messfläche des Halbleiterbauelementes (1), mit elektromagnetischer Anregungsstrahlung zur Trennung von Ladungsträgerpaaren in dem Halbleiterbauelement (1) und
   B ortsaufgelöste Messung von dem Halbleiterbauelement (1) ausgehender elektromagnetischer Strahlung mittels mindestens einer Detektionseinheit,

   wobei in mindestens einem Schritt A mindestens ein vorgegebener Anregungsteilbereich der Messfläche mit einer für diesen Anregungsteilbereich vorgegebenen Intensität der Anregungsstrahlung beaufschlagt wird und mindestens ein Senkenteilbereich der Messfläche mit einer gegenüber dem Anregungsteilbereich geringeren Intensität der Anregungsstrahlung beaufschlagt wird und/oder dass für mindestens einen vorgegebenen Senkenteilbereich die Intensität 0 für die Anregungsstrahlung vorgegeben ist, so dass mindestens ein Senkenteilbereich in Schritt A nicht mit Anregungsstrahlung beaufschlagt wird
   **dadurch gekennzeichnet,**
   **dass** Anregungs- und Senkenteitbereich auf gegenüberliegenden Seiten des Kontaktierungsteilbereiches angeordnet sind und an diesen angrenzen und/oder diesen ganz oder teilweise überlappen.

2. Verfahren nach Anspruch 1,
   **dadurch gekennzeichnet,**
   **dass** die Messfläche durch einen oder mehreren Kontaktierungsteilbereiche in Segmente unterteilt wird,
   **dass** in mindestens einem Schritt A mindestens ein Anregungsteilbereich mindestens ein Segment, vorzugsweise genau ein Segment, überdeckt und die zu diesem Anregungsteilbereich benachbarten Segmente durch Senkenteilbereiche überdeckt sind.

3. Verfahren nach mindestens einem der vorangegangenen Ansprüche,
   **dadurch gekennzeichnet,**
   **dass** in mindestens einem Schritt A mindestens ein Anregungsteitbereich eine gemeinsame Begrenzung mit dem Kontaktierungsteilbereich aufweist, vorzugsweise,
   **dass** in allen Schritten A alle Anregungsteilbereiche eine gemeinsame Begrenzung mit einem jeweils vorgegebenen Kontaktierungsteilbereich aufweisen.

4. Verfahren nach Anspruch 3,
   **dadurch gekennzeichnet,**
   **dass** sich der Anregungsteilbereich entlang einer Seite des Kontäktierungsteilbereiches erstreckt, insbesondere,
   **dass** sich in allen Schritten A alle Anregungsteilbereiche entlang einer Seite eines jeweils vorgegebenen Kontaktierungsteitbereiches erstrecken.

5. Verfahren nach einem der vorangegangenen Ansprüche,
   **dadurch gekennzeichnet,**
   **dass** in mindestens einem Schritt A mindestens ein Anregungsteilbereich durch den Rand des Kontaktierungsteilbereiches sowie weiterhin durch weitere vorgegebene Kontaktierungsteilbereiche und/oder weiterhin durch einen oder mehrere Ränder des Halbleiterbauelementes begrenzt ist.

6. Verfahren nach mindestens einem der vorangegangenen Ansprüche,
dadurch gekenntzeichnet,
dass der Kontaktierungsteilbereich ein Busbar-Kontaktierungsteilbereich ist, der von einem Busbar bedeckt ist oder zu Bedeckung durch einen Busbar vorgesehen ist, insbesondere,
dass das Halbleiterbauelement eine Mehrzahl von *b* Busbar-Kontaktierungsteilbereichen aufweist und in jedem Schritt A mindestens $1/(2b)$, vorzugsweise mindestens $1/b$ der Fläche der Messfläche durch den oder die Anregungsteilbereiche abgedeckt ist.

7. Verfahren nach mindestens einem der vorangegangenen Ansprüche,
**dadurch gekennzeichnet,**
**dass** in jedem Schritt A mindestens 1/6, vorzugsweise mindestens ¼ der Fläche der Messfläche durch den oder die Anregungsteilbereiche abgedeckt ist, insbesondere,
**dass** in jedem Schritt A in etwa die Hälfte der Fläche der Messfläche durch den oder die Anregungsteilbereiche abgedeckt ist.

8. Verfahren nach mindestens einem der vorangegangenen Ansprüche,
**dadurch gekennzeichnet,**
**dass** Schritt A mindestens zweimal ausgeführt wird, wobei jeweils zeine Messung gemäß Schritt B erfolgt und die Schritte A unterschiedliche Anregungsteilbereiche aufweisen.

9. Verfahren nach mindestens einem der vorangegangenen Ansprüche,
**dadurch gekennzeichnet,**
**dass** alle Anregungsteilbereiche aller Schritte A zusammengenommen zumindest die Messfläche außerhalb der Köntaktierungsbereiche abdecken, insbesondere,
**dass** alle Anregungsteilbereiehe aller Schritte A zusammengenommen die gesamte Messfläche abdecken.

10. Verfahren nach mindestens einem der vorangegangen Ansprüche,
**dadurch gekennzeichnet,**
**dass** für sämtliche Senkenteilbereiche die Intensität 0 vorgegeben ist.

11. Verfahren nach mindestens einem der vorangegangenen Ansprüche,
**dadurch gekennzeichnet,**
**dass** in jedem Schritt A Anregungsteilbereiche und Senkenteilbereiche zusammengenommen zumindest die Messfläche außerhalb der Kontaktierungsbereiche abdecken, insbesondere die gesamte Messfläche abdecken.

12. Verfahren nach einem der vorangegangenen Ansprüche,
**dadurch gekennzeichnet"**
dass die Anregungsteilbereiche aller Schritte A disjunkt sind, insbesondere paarweise disjunkt und/oder
dass in mindestens einem Schritt A alle Anregungsteilbereiche konvex sind, insbesondere, dass in allen Schritten A alle Anregungsteilbereiche konvex sind.

13. Verfahren nach mindestens einem der vorangegangenen Ansprüche,
**dadurch gekennzeichnet,**
**dass** in einem weiteren Schritt A' die Vorder- und/oder Rückseite des Halbleiterbauelementes (1), vorzugsweise die Messfläche, ganzflächig und hinsichtlich der Strahlungsintensität homogen mit Anregungsstrahlung beaufschlagt wird und eine Messung gemäß Schritt B erfolgt, insbesondere,
**dass** insgesamt drei Messungen durchgeführt werden, wobei in zwei Messungen verschiedene Teilbereiche mit Anregungsstrahlung beaufschlagt werden und in einer dritten Messung das Halbleiterbauelement (1) ganzflächig und homogen mit Anregungsstrahlung beaufschlagt wird, insbesondere,
**dass** in einem Auswerteschritt für jeden Ortspunkt *i* eine Auswertung gemäß Formel 1 erfolgt

$$ME_i = \ln(M1_i + M2_i) - \ln(M3_i) \, ; \quad \forall i\,(1,...,n) \qquad \text{(Formel 1)}$$

d.h. bei insgesamt n Messpunkten wird das Messergebnis $ME_i$ für jeden Ortspunkt *i* gemäß Formel 1 abhängig von den Messwerten für den Ortspunkt i aus der ersten Messung $M1_i$, aus der zweiten Messung $M2_i$, und aus

der dritten Messung $M3_i$ bestimmt.

**14.** Verfahren nach mindestens einem der vorangegangenen Ansprüche,
**dadurch gekennzeichnet,**
**dass** die Schritte A und B gleichzeitig ausgeführt werden.

**15.** Messvorrichtung für eine Halbleiterbauelement, (1) mit einer Vorder- und einer Rückseite, umfassend eine Strahlungsquelle zur flächigen Beaufschlagung der Vorder- und/oder Rückseite des Halbleiterbauelementes (1) mit Anregungsstrahlung und eine Detektionseinheit, zur ortsaufgelösten Messung von dem Halbleiterbauelement (1) ausgehender elektromagnetischer Strahlung,
welche Messvorrichtung weiterhin eine Modifikationseinheit umfasst, welche im Strahlengang der Strahlungsquelle zwischen Halbleiterbauelement (1) und Strahlungsquelle angeordnet ist und
welche Modifikationseinheit mindestens einen optischen Filter umfasst, welcher wahlweise in dem Strahlengang zwischen Strahlungsquelle- und Halbleiterbauelement (1) anordbar ist, wobei mittels des optischen Filters der Strahl der Strahlungsquelle in vorgegebenen Teilbereichen hinsichtlich der Intensität und/oder der spektralen Zusammensetzung beeinflussbar ist,
**dadurch gekennzeichnet,**
**dass** die Messvörrichtüng ausgebildet its zur Charakterisierung eines Halbleiterbauelementes mit einer Messfläche, welche die Vorder- und/oder Rückseite des Halbleiterbauelementes ist und welche mindestens einen Kontaktierurigsteilbereich aufweist, der mit einer Köntaktierungsstruktur bedeckt ist oder- zur Bedeckung mit einer Kontaktierungsstruktur vorgesehen ist,
indem die Modifikationseinheit derart ausgebildet ist, dass mindestens ein vorgegebener Anregungsteilbereich der Messfläche mit einer für diesen Anregungsteilbereich vorgegebenen Intensität der Ariregungsstrahlung beaufschlagbar ist und
mindestens ein Senkenteilbereich der Messfläche mit einer gegenüber dem Anregungsteilbereich geringeren Intensität der Antegungsstrahlung beaufschlagbar ist und/oder dass für mindestens einen vorgegebenen Senkenteilbereich die Intensität 0 für die Anregungsstrahlung vorgebar ist, wobei
Anregungs- und Senkenteilbereicn auf gegenüberliegenden Seiten des Kontaktierungsteilbereiches angeordnet sind und an diesen angrenzen und/oder diesen ganz oder teilweise überlappen.

**16.** Messvorrichtüng nach Anspruch 15,
**dadurch gekennzeichnet,**
**dass** die Modifikationsenheit eine Halterung umfasst, an der mindestens ein optischer Filter schenkbar angeordnet ist, derart, dass er wahlweise in eine Stellung parallel und eine Stellung senkrecht zur Hauptachse des Strahls der Strahlungsquelle schwenkbar ist, insbesondere,
**dass** die Modifikationseinheit eine Schwenkvorrichtung umfasst, welche mit dem optischen Filter derart in Wirkverbindung steht, zum Verschwenken des, optische Filters relativ zur Hauptachse des Strahls der Strahlungsquelle, insbesondere, dass die Schwenkvorrichtung mittels elektrischer Steuersignale steuerbar ist und/oder
**dass** die Vorrichtung zur Vermessung eines Halbleiterbauelement (1) mit mindestens einer Metallisierungslinie (2a, 2b) ausgebildet ist und der optische Filter derart an der Modifikationseinheit angeordnet ist, dass bei Ausrichtung des optischen Filters parallel zur Hauptachse- des Strahls der Strahlungsquelle die verbleibende Abschattung durch diesen Filter in etwa einen Teilbereich des Strahl der Strahlungsquelle betrifft, welcher der linienartigen Metallisierungslinie (2a, 2b) zugeordnet ist.

**Claims**

**1.** Measuring method for characterising a semiconductor element (1) with at least one pn junction and one measurement area which is a front and/or rear face of the semiconductor element and which has at least one contacting sub-area which is covered with a contacting structure or is provided for covering with a contacting structure, comprising the following steps:

A) planar application of electromagnetic excitation radiation to the measurement area of the semiconductor element (1) for separation of charge carrier pairs in the semiconductor element (1), and
B) spatially resolved measurement of electromagnetic radiation coming from the semiconductor element (1) by means of at least one detection unit,

wherein in at least one step A excitation radiation at an intensity predetermined for the excitation sub-area is applied to at least one predetermined excitation sub-area of the measurement area and excitation radiation at a lower intensity relative to that of the excitation sub-area is applied to at least one sink sub-area of the measurement area, and/or for at least one predetermined sink sub-area the intensity 0 is predetermined for the excitation radiation, so that excitation radiation is not applied to at least one sink sub-area in step A, **characterised in that** excitation and sink sub-areas are disposed on opposing sides of the contacting sub-area and border this area and/or completely or partially overlap this area.

2. Method as claimed in Claim 1, **characterised in that** the measurement area is divided into segments by one or more of the contacting sub-areas, that in at least one step A at least one excitation sub-area covers at least one segment, preferably exactly one segment, and the segments adjacent to this excitation sub-area are covered by sink sub-areas.

3. Method as claimed in any one of the preceding claims, **characterised in that** in at least one step A at least one excitation sub-area has a common border with the contacting sub-area, and preferably that in all steps A all excitation sub-areas have a common border with a respectively predetermined contacting sub-area.

4. Method as claimed in Claim 3, **characterised in that** the excitation sub-area extends along one side of the contacting sub-area, and in particular that in all steps A all excitation sub-areas extend along one side of a respectively predetermined contacting sub-area.

5. Method as claimed in any one of the preceding claims, **characterised in that** in at least one step A at least one excitation sub-area is delimited by the edge of the contacting sub-area as well as, furthermore, by further predetermined contacting sub-areas and/or furthermore by one or more edges of the semiconductor element.

6. Method as claimed in at least one of the preceding claims, **characterised in that** the contacting sub-area is a busbar contacting sub-area which is covered by a busbar or is provided for covering by a busbar, and in particular that the semiconductor element has a plurality of b busbar contacting sub-areas and in each step A preferably at least 1/(2b), preferably at least 1/b of the area of the measurement area is covered by the excitation sub-area or sub-areas.

7. Method as claimed in at least one of the preceding claims, **characterised in that** in each step A at least 1/6, preferably at least 1/4 of the area of the measurement area is covered by the excitation sub-area or sub-areas, and in particular that in each step A approximately half the area of the measurement area is covered by the excitation sub-area or sub-areas.

8. Method as claimed in at least one of the preceding claims, **characterised in that** step A is performed at least twice, wherein in each case a measurement according to step B takes place and the steps A have different excitation sub-areas.

9. Method as claimed in at least one of the preceding claims, **characterised in that** all excitation sub-areas of all steps A taken together cover at least the measurement area outside the contacting areas, and in particular that all excitation sub-areas of all steps A taken together cover the entire measurement area.

10. Method as claimed in at least one of the preceding claims, **characterised in that** the intensity 0 is predetermined for all sink sub-areas.

11. Method as claimed in at least one of the preceding claims, **characterised in that** in each step A the excitation sub-areas and the sink sub-areas taken together cover at least the measurement area outside the contacting areas, and in particular cover the entire measurement area.

12. Method as claimed in at least one of the preceding claims, **characterised in that** the excitation sub-areas of all steps A are disjoint, and in particular disjoint in pairs, and/or that in at least one step A all of the excitation sub-areas are convex, and in particular that in all steps A all excitation sub-areas are convex.

13. Method as claimed in at least one of the preceding claims, **characterised in that** in a further step A' excitation radiation is applied to the front and/or the rear face of the semiconductor element (1), preferably the measurement area, over the entire surface and homogeneously with regard to the radiation intensity, and a measurement according to step B is carried out, and that in particular overall three measurements are performed, wherein in two measurements the excitation radiation is applied to different sub-areas and in a third measurement the excitation radiation is applied to the semiconductor element (1) over the entire surface and homogeneously, and in particular that in an evaluation step for each location point i an evaluation is performed according to Formula 1

$$ME_i = \ln(M1_i + M2_i) - \ln(M3_i); \quad \forall i(1,\ldots,n) \text{ (Formula 1)}$$

i.e. in the case of a total of $n$ measurement points the measurement result $ME_i$ for each location point $i$ according to Formula 1 is dependent upon the measurement values for the location point $i$ from the first measurement $M1_i$, from the second measurement $M2_i$, and from the third measurement $M3_i$.

14. Method as claimed in at least one of the preceding claims, **characterised in that** steps A and B are performed simultaneously.

15. Measuring device for a semiconductor element (1) with a front and a rear face, comprising a radiation source for the planar application of excitation radiation to the front and/or rear face of the semiconductor element (1) and a detection unit for the spatially resolved measurement of electromagnetic radiation coming from the semiconductor element (1), which measuring device furthermore comprises a modification unit which is disposed in the beam path of the radiation source between the semiconductor element (1) and radiation source, and which modification unit comprises at least one optical filter which can be disposed selectively in the beam path between the radiation source and the semiconductor element (1), wherein by means of the optical filter the beam from the radiation source can be influenced in predetermined sub-areas with regard to the intensity and/or the spectral composition, **characterised in that** for characterising a semiconductor element the measuring device is constructed with a measurement area which is the front and/or rear face of the semiconductor element and which has at least one contacting sub-area which is covered with a contacting structure or is provided for covering with a contacting structure, wherein the modification is constructed in such a way that excitation radiation at an intensity predetermined for the excitation sub-area is applied to at least one predetermined excitation sub-area of the measurement area and excitation radiation at a lower intensity relative to that of the excitation sub-area is applied to at least one sink sub-area of the measurement area, and/or for at least one predetermined sink sub-area the intensity 0 is predetermined for the excitation radiation, wherein the excitation and sink sub-areas are disposed on opposing sides of the contacting sub-area and border this area and/or completely or partially overlap this area.

16. Measuring device as claimed in Claim 15, **characterised in that** the modification unit comprises a holder on which at least one optical filter is disposed so as to be pivotable in such a way that it can pivot selectively into a position parallel to and into a position perpendicular to the main axis of the beam from the radiation source, and that in particular the modification unit comprises a pivoting device which operatively connected to the optical filter in such a way that for pivoting the optical filter relative to the main axis of the beam from the radiation source in particular the pivoting device can be controlled by means of electrical control signals, and/or that the device for measuring a semiconductor element (1) is constructed with at least one metallisation line (2a, 2b) and the optical filter is disposed on the modification unit in such a way that in the case of alignment of the optical filter parallel to the main axis of the beam from the radiation source the remaining shadow by this filter approximately concerns a sub-area of the beam from the radiation source which is allocated to the linear metallisation line.

## Revendications

1. Procédé de mesure ciblant la caractérisation d'un composant (1) à semi-conducteurs présentant au moins une jonction pn et une surface de mesure matérialisée par la face antérieure et/ou la face postérieure dudit composant à semi-conducteurs, et comportant au moins une région partielle de mise en contact qui est recouverte par une structure de mise en contact, ou est prévue pour le recouvrement par une structure de mise en contact, comprenant les étapes suivantes :

A sollicitation du plan de la surface de mesure du composant (1) à semi-conducteurs par un rayonnement excitateur électromagnétique, en vue de la séparation de paires de porteurs de charge dans ledit composant (1) à semi-conducteurs, et
B mesure à résolution spatiale d'un rayonnement électromagnétique provenant dudit composant (1) à semi-conducteurs, à l'aide d'au moins une unité de détection,

sachant que, lors d'au moins une étape A, au moins une zone d'excitation partielle préétablie de ladite surface de mesure est sollicitée par une intensité du rayonnement excitateur préétablie pour cette zone d'excitation partielle, et au moins une zone partielle de puits de ladite surface de mesure est sollicitée par une intensité dudit rayonnement excitateur qui est moindre comparativement à ladite zone d'excitation partielle, et/ou sachant que l'intensité 0 affectée audit rayonnement excitateur est préétablie, pour au moins une zone partielle de puits préétablie, de façon telle qu'au moins une zone partielle de puits ne soit pas sollicitée par un rayonnement excitateur, lors d'une étape A, **caractérisé par le fait**

**que** des zones partielles d'excitation et de puits se trouvent sur des côtés opposés de la région partielle de mise en contact et sont limitrophes de cette dernière, et/ou chevauchent cette dernière en totalité ou en partie.

2. Procédé selon la revendication 1,
**caractérisé par le fait**
**que** la surface de mesure est scindée en des segments par une ou plusieurs région(s) partielle(s) de mise en contact,
**que**, lors d'au moins une étape A, au moins une zone d'excitation partielle recouvre au moins un segment, de préférence exactement un segment, et les segments voisins de cette zone d'excitation partielle sont recouverts par des zones partielles de puits.

3. Procédé selon au moins l'une des revendications précédentes,
**caractérisé par le fait**
**que**, lors d'au moins une étape A, au moins une zone d'excitation partielle présente une délimitation commune avec la région partielle de mise en contact, de préférence que, durant toutes les étapes A, toutes les zones d'excitation partielles présentent une délimitation commune avec une région partielle de mise en contact respectivement préétablie.

4. Procédé selon la revendication 3,
**caractérisé par le fait**
**que** la zone d'excitation partielle s'étend le long d'un côté de la région partielle de mise en contact, notamment
**que**, durant toutes les étapes A, toutes les zones d'excitation partielles s'étendent le long d'un côté d'une région partielle de mise en contact respectivement préétablie.

5. Procédé selon l'une des revendications précédentes,
**caractérisé par le fait**
**que**, lors d'au moins une étape A, au moins une zone d'excitation partielle est délimitée par le bord de la région partielle de mise en contact, ainsi qu'en outre par d'autres régions partielles préétablies de mise en contact et/ou, en outre, par un ou plusieurs bord(s) du composant à semi-conducteurs.

6. Procédé selon au moins l'une des revendications précédentes,
**caractérisé par le fait**
**que** la région partielle de mise en contact est une région partielle de mise en contact de barre omnibus, recouverte par une barre omnibus ou prévue pour le recouvrement par une barre omnibus, notamment
**que** le composant à semi-conducteurs présente une pluralité de $b$ régions partielles de mise en contact de barres omnibus et,
durant chaque étape A, au moins $1/(2b)$, de préférence au moins $1/b$ de la superficie de la surface de mesure est recouvert par la ou les zone(s) d'excitation partielle(s).

7. Procédé selon au moins l'une des revendications précédentes,
**caractérisé par le fait**
**que**, durant chaque étape A, au moins 1/6, de préférence au moins 1/4 de la superficie de la surface de mesure est recouvert par la ou les zone(s) d'excitation partielle(s), notamment
**que**, durant chaque étape A, sensiblement la moitié de la superficie de ladite surface de mesure est recouverte par la ou les zone(s) d'excitation partielle(s).

8. Procédé selon au moins l'une des revendications précédentes,
**caractérisé par le fait**
**que** l'étape A est exécutée au moins deux fois, sachant qu'il s'opère respectivement une mesure conforme à l'étape B, et que les étapes A présentent différentes zones d'excitation partielles.

9. Procédé selon au moins l'une des revendications précédentes,

**caractérisé par le fait**
**que** toutes les zones d'excitation partielles de toutes les étapes A, prises ensemble, recouvrent au moins la surface de mesure à l'extérieur des régions partielles de mise en contact, notamment
**que** toutes les zones d'excitation partielles de toutes les étapes A, prises ensemble, recouvrent l'intégralité de ladite surface de mesure.

10. Procédé selon au moins l'une des revendications précédentes,
**caractérisé par le fait**
**que** l'intensité 0 est préétablie pour toutes les zones partielles de puits.

11. Procédé selon au moins l'une des revendications précédentes,
**caractérisé par le fait**
**que**, durant chaque étape A, des zones d'excitation partielles et des zones partielles de puits recouvrent, prises ensemble, au moins la surface de mesure à l'extérieur des régions partielles de mise en contact et recouvrent, en particulier, l'intégralité de ladite surface de mesure.

12. Procédé selon l'une des revendications précédentes,
**caractérisé par le fait**
**que** les zones d'excitation partielles de toutes les étapes A sont dissociées, notamment dissociées par paires, et/ou
**que**, lors d'au moins une étape A, toutes les zones d'excitation partielles sont convexes, notamment que toutes lesdites zones d'excitation partielles sont convexes durant toutes les étapes A.

13. Procédé selon au moins l'une des revendications précédentes,
**caractérisé par le fait**
**que**, lors d'une autre étape A', la (les) face(s) antérieure et/ou postérieure du composant (1) à semi-conducteurs, de préférence la surface de mesure, est (sont) sollicitée(s) par un rayonnement excitateur sur toute la superficie, et de manière homogène quant à l'intensité dudit rayonnement, et il s'opère une mesure conforme à l'étape B, notamment que des mesures au nombre total de trois sont effectuées, sachant que différentes zones partielles sont sollicitées par un rayonnement excitateur lors de deux mesures et que, lors d'une troisième mesure, ledit composant (1) à semi-conducteurs est sollicité par un rayonnement excitateur sur toute la superficie, et de manière homogène, notamment qu'une interprétation conforme à la formule 1 est effectuée pour chaque point localisé i, lors d'une étape d'interprétation,

$$ME_i = \ln(M1_i + M2_i) - \ln(M3_i) \; ; \; \forall \, i \, (1,\dots, n) \quad (\text{formule 1}),$$

c'est-à-dire que, pour un nombre total de $n$ points de mesure, le résultat $ME_i$ de la mesure est déterminé pour chaque point localisé $i$, conformément à ladite formule 1, en fonction des valeurs mesurées relatives au point localisé $i$ résultant de la première mesure $M1_i$, de la deuxième mesure $M2_i$ et de la troisième mesure $M3_i$.

14. Procédé selon au moins l'une des revendications précédentes,
**caractérisé par le fait**
**que** les étapes A et B sont exécutées en simultanéité.

15. Dispositif de mesure dévolu à un composant (1) à semi-conducteurs muni d'une face antérieure et d'une face postérieure, comprenant
une source de rayonnement destinée à la sollicitation du plan de la (des) face(s) antérieure et/ou postérieure dudit composant (1) à semi-conducteurs par un rayonnement excitateur,
et
une unité de détection dédiée à la mesure à résolution spatiale d'un rayonnement électromagnétique provenant dudit composant (1) à semi-conducteurs,
lequel dispositif de mesure inclut, par ailleurs, une unité de modification interposée entre le composant (1) à semi-conducteurs et la source de rayonnement, sur le trajet des rayons de ladite source de rayonnement, et
ladite unité de modification comportant au moins un filtre optique pouvant être sélectivement placé sur le trajet des rayons entre ladite source de rayonnement et ledit composant (1) à semi-conducteurs, ledit filtre optique permettant d'influencer l'intensité et/ou la composition spectrale du rayon de ladite source de rayonnement dans des zones partielles préétablies,

**caractérisé par le fait**

**que** ledit dispositif de mesure est conçu en vue de la caractérisation d'un composant à semi-conducteurs présentant une surface de mesure matérialisée par la face antérieure et/ou la face postérieure dudit composant à semi-conducteurs, et comportant au moins une région partielle de mise en contact qui est recouverte par une structure de mise en contact, ou est prévue pour le recouvrement par une structure de mise en contact,

du fait que ladite unité de modification est réalisée de telle sorte qu'au moins une zone d'excitation partielle préétablie de ladite surface de mesure puisse être sollicitée par une intensité du rayonnement excitateur préétablie pour cette zone d'excitation partielle, et qu'au moins une zone partielle de puits de ladite surface de mesure puisse être sollicitée par une intensité dudit rayonnement excitateur qui est moindre comparativement à ladite zone d'excitation partielle, et/ou que l'intensité 0 affectée audit rayonnement excitateur puisse être préétablie pour au moins une zone partielle de puits préétablie, sachant que des zones partielles d'excitation et de puits se trouvent sur des côtés opposés de la région partielle de mise en contact et sont limitrophes de cette dernière, et/ou chevauchent cette dernière en totalité ou en partie.

16. Dispositif selon la revendication 15,
**caractérisé par le fait**

**que** l'unité de modification est pourvue d'un support sur lequel au moins un filtre optique est implanté avec aptitude pivotante, de manière à pouvoir sélectivement pivoter vers une position parallèle, et vers une position perpendiculaire à l'axe principal du rayon de la source de rayonnement, notamment

**que** ladite unité de modification inclut un dispositif de pivotement en liaison interactive avec ledit filtre optique, de manière à imprimer des pivotements audit filtre optique vis-à-vis dudit axe principal du rayon de ladite source de rayonnement, notamment que ledit dispositif de pivotement peut être commandé au moyen de signaux électriques de commande, et/ou

**que** le dispositif, affecté à la mesure d'un composant (1) à semi-conducteurs, est doté d'au moins une ligne de métallisation (2a, 2b) et ledit filtre optique occupe, sur ladite unité de modification, une position telle que, lors d'un alignement dudit filtre optique parallèlement audit axe principal du rayon de ladite source de rayonnement, l'occultation persistante, provoquée par ce filtre, concerne sensiblement une zone partielle du rayon de ladite source de rayonnement à laquelle est associée ladite ligne de métallisation (2a, 2b) de type linéaire.

**Figur 1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2007041758 A1
- EP 1758178 A2
- EP 08887652 A2

**In der Beschreibung aufgeführte Nicht-Patentliteratur**

- **T. TRUPKE ; E. PINK ; R.A. BARDOS ; M.D. AB-BOTT.** Spatially resolved series resistance of silicon solar cells obtained from luminescence imaging. *Applied Physics Letters,* 2007, vol. 90, 093506
- **J. ISENBERG ; W. WARTA.** *J. Appl. Phys.,* 2004, vol. 95 (9), 5200